(19) Europäisches Patentamt
European Patent Office
Office européen des brevets

(11) **EP 2 579 049 B1**

(12) **EUROPEAN PATENT SPECIFICATION**

(45) Date of publication and mention
of the grant of the patent:
**02.12.2020 Bulletin 2020/49**

(51) Int Cl.:
*G01R 21/06* (2006.01)      *G01R 15/16* (2006.01)
*H01G 5/16* (2006.01)      *G01R 17/08* (2006.01)

(21) Application number: **12187094.3**

(22) Date of filing: **03.10.2012**

(54) **Method and device for measuring the electric power propagating in a conductor**

Verfahren und Vorrichtung zur Messung der in einem Leiter transportierten elektrischen Leistung

Procédé et dispositif de mesure de la propagation de l'énergie électrique dans un conducteur

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **05.10.2011 FI 20115977**

(43) Date of publication of application:
**10.04.2013 Bulletin 2013/15**

(73) Proprietor: **Teknologian tutkimuskeskus VTT Oy 02150 Espoo (FI)**

(72) Inventors:
• **Immonen, Pekka**
  **00720 Helsinki (FI)**
• **Hällström, Jari**
  **03100 Nummela (FI)**

(74) Representative: **Berggren Oy, Helsinki & Oulu P.O. Box 16**
  **Eteläinen Rautatiekatu 10A**
  **00101 Helsinki (FI)**

(56) References cited:
EP-A1- 2 169 700      WO-A1-2006/040403
WO-A1-2007/101916      WO-A2-00/02110
US-A1- 2006 267 558

• **VOHO-HEIKKILO T ET AL: "Design of capacitive RF MEMS power sensor", INTERNET CITATION, 17 October 2002 (2002-10-17), XP003013021, Retrieved from the Internet: URL:http://www.tkk.fi/Units/Radio/URSI02/u rsi_vaha-heikkila.pdf [retrieved on 2002-10-17]**
• **SEPPA H ET AL: "Microelectromechanical systems in electrical metrology", IEEE TRANSACTIONS ON INSTRUMENTATION AND MEASUREMENT, IEEE SERVICE CENTER, PISCATAWAY, NJ, US, vol. 50, no. 2, 14 May 2000 (2000-05-14), pages 440-444, XP002991674, ISSN: 0018-9456, DOI: 10.1109/19.918161**

EP 2 579 049 B1

**Description**

**Technical field**

The application relates generally to a method and device for measuring the electric power propagating in a conductor.

**Background**

The measurement of electric power $P$ is based on determining the product of voltage $U$ and current $I$. This can be carried out by digitizing voltage and current signals and further by conducting the multiplication digitally. Another generally applied practice is a multiplication method based on the modulation of a pulse width and height.
Electric power and energy have been traditionally also measured with devices based on various mechanical force actions, such as with a traditional induction meter, wherein the eddy currents generated by electric power flowing through an electromagnet bring an aluminum disc present in the magnetic field to rotation at a rotation speed proportional to the electric power. Another possible measuring practice is to make use of the Lorentz force generated by the current flowing in an inductor and by the magnetic field, such that a current proportional to the voltage is fed into the inductor which is located in a magnetic field generated by the current conductor.
Patent FI 1118931 B proposes that the latter measurement method be applied by using a microelectromechanical component (microelectromechanical system, MEMS). A weakness in the method is its sensitivity regarding how to dispose the component's inductor with respect to the current conductor and how to provide protection against external interference fields.

**Summary**

It is one objective of the invention to eliminate some of the foregoing problems and to enable the construction of a power meter, which is small in size, compact, and readily protectable from external interferences, and in which the measurement of power is based on a force action between capacitor plates, said action being proportional to the square of a voltage coupled between the plates.
The one objective of the invention is achieved by the method of claim 1 and by the device of claim 8.
In a method according to one embodiment of the invention, the electric power propagating in a conductor is measured with a flip-flop, which is adapted to move relative to an axle and which has electrodes on the opposite surfaces of the flip-flop and/or on both sides of its axle, each of said electrodes of the flip-flop being adapted to make up part of a capacitive element. The method comprises providing a first element and a second element, present on the opposite surfaces of the flip-flop and/or on both sides of its axle, with voltage signals having an effect on the flip-flop's position and being dependent on the electric power to be measured, observing by means of a measuring element a change in the flip-flop's position caused by a change in the voltage signals, and balancing the flip-flop by changing, on the basis of the change in the flip-flop's position, a voltage signal which is to be delivered to a balancing element and which is, for example squarely, proportional to the electric power to be measured.
The term "flip-flop" is used in reference to a rigid body capable of rotating around its axle. The axle can be disposed between the ends of a rigid body, for example in the middle of a rigid body, or at one of the ends of a rigid body. Rotation of the flip-flop around the axle out of the position of equilibrium is opposed for example by a springback force. An example of a direct-current reference flip-flop which is used for force-balance measurements as in microphones, sensitive pressure sensors, MEMS-based microwave power measurements, and similar, is disclosed in WO2006040403.
In a device according to one embodiment of the invention for measuring the electric power propagating in a conductor is included a flip-flop, which is adapted to move relative to an axle and which has electrodes on the opposite surfaces of the flip-flop and/or on both sides of its axle, each of said electrodes of the flip-flop being adapted to make up part of a capacitive element. The device is further provided with a measuring unit, which is adapted to generate voltage signals for a first element and a second element present on the opposite surfaces of the flip-flop and/or on both sides of its axle, said signals having an effect on the flip-flop's position and being dependent on the electric power to be measured, to observe by means of a measuring element a change in the flip-flop's position caused by a change in the voltage signals, and to balance the flip-flop by changing, on the basis of the change in the flip-flop's position, a voltage signal which is to be delivered to a balancing element and which is, for example squarely, proportional to the electric power to be measured.
Other embodiments of the invention are presented in the dependent claims.
The method and device according to various embodiments of the invention enable a configuration of the power or energy meter as a small-sized compact device with manufacturing costs in mass production remaining low.
The method and the small-sized device according to various embodiments of the invention enable measuring the energy consumption of an individual apparatus and, when connected to the data collection system of a smart electrical network, the power meter can be used as an auxiliary means in the network management as well as in the implementation of energy saving measures.

The method and device according to various embodiments of the invention can be utilized in precision measurements of power and energy, and also as a reference normal for electric power.

## Brief description of the figures

Exemplary embodiments of the invention will be discussed more specifically in the detailed description of the figures with reference to the accompanying figures, in which

figs. 1a-1c    show a flip-flop structure for a device intended for measuring electric power for generating the sum and difference signals of a voltage circuit and for measuring the capacitance of a measuring circuit,

fig. 2    shows functional units for a device intended for measuring electric power, and

fig. 3    shows a flow chart for an electric power measuring method.

## Detailed description of the figures

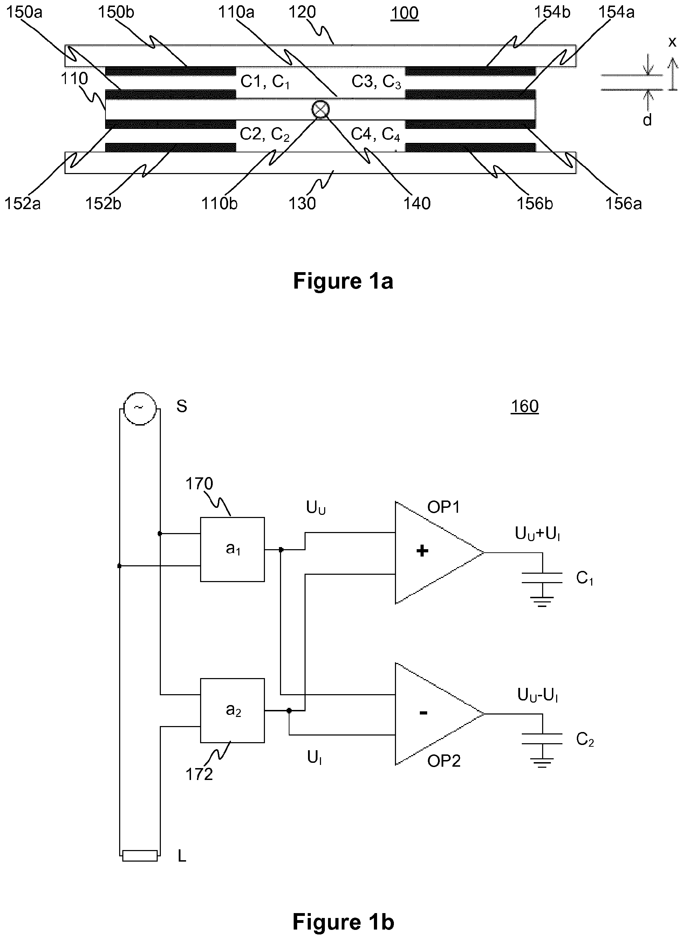

Fig. 1a shows a flip-flop structure 100 for a silicon-constructed MEMS sensor intended for measuring electric power flowing in a conductor, wherein a rigid beam type flip-flop 110 lies between two silicon-constructed body sections 120, 130. The flip-flop has its top surface 110a towards the top body section 120 and its bottom surface 110b towards the bottom body section 130. Alternatively, the employed sensor substrate may comprise for example glass, quartz or a metal, for example steel.

The flip-flop may also have a length in centimeter class, for example 5 cm, i.e. "considerably" larger than even a microsensor. Thus, the sensor size can be designed according to intended application.

The flip-flop 110 is adapted to rotate around its axle 140 with a springback force opposing a deviation from the position of equilibrium, and it is constructed with electrodes 150a, 152a, 154a, 156a for example of aluminum, aluminum alloys, molybdenum, tantalum, tungsten or copper, such that the flip-flop has its top surface 110a provided with the electrodes 150a, 154a and its bottom surface 110b with the electrodes 152a, 156a. Respectively, the top and bottom body sections 120, 130 are constructed with electrodes 150b, 152b, 154b, 156b for example of aluminum, aluminum alloys, molybdenum, tantalum, tungsten or copper.

The electrodes 150a, 150b establish between the flip-flop 110 and the body section 120 a capacitor C1 with a capacitance $C_1$, and the electrodes 152a, 152b provide between the flip-flop 110 and the body section 130 a bottom capacitor C2 with a capacitance $C_2$. On the other side of the axle 140, respectively, the electrodes 154a, 154b establish a measuring capacitor C3 with a capacitance $C_3$, and the electrodes 156a, 156b a balancing capacitor C4 with a capacitance $C_4$. The capacitors C1, C2, C3, C4 functioning as capacitive elements are positioned on either side of the axle 140 towards the ends of the flip-flop 110.

A device according to one embodiment of the invention, as set forth in any of the preceding embodiments, is a capacitive micromechanical sensor, having on a first side of its axle, on the opposite faces thereof, first and second capacitive elements, and on a second side of its axle, on the opposite faces thereof, a capacitive measuring element and a capacitive balancing element.

Alternatively, at least some of the capacitors C1, C2, C3, C4 can be positioned closer to the axle 140 and/or the capacitors C1, C2 can be positioned, unlike in the figure, on different sides of the axle 140 either on the same surface 110a, 110b or in such a way that one of the capacitors C1, C2 is at the flip-flop's top surface 110a and the other on the other side of the axle at the bottom surface 110b. In addition, an optional way of constructing the flip-flop structure 100 is such that the axle 140, relative to which the flip-flop 110 is able to rotate, is constructed at one end of the flip-flop 110 and the capacitors C1, C2, C3, C4 are positioned at the other end, thus increasing the trajectory thereof.

When, for example, across the capacitor C1 is applied the voltage U, the result is a force between the capacitor plates 150a, 150b to rotate the rigid flip-flop 110

$$F_{E,V} = -\frac{d}{dx}\left(\frac{C_1 U}{2}\right) = \frac{1}{2} U^2 \frac{\varepsilon A}{(d-x)^2} \tag{1}$$

wherein $\varepsilon$ is the permittivity of a medium present between the capacitor plates 150a, 150b, $A$ is the area of capacitor plates, $d$ the distance between the same at zero voltage, and $x$ the deviation of distance from the initial position.

Accordingly, the force $F_{E,V}$ is proportional to the square of the voltage $U$ and, irrespective of polarity, always in such a direction that it endeavors to draw the capacitor plates 150a, 150b closer to each other. With the flip-flop 110 in equilibrium state, the electrical forces acting through each capacitor C1, C2, C3, C4, and the springback force generated by the axle 140 and proportional to rotation of the flip-flop 110, cancel each other.

In a device according to one embodiment of the invention, as set forth in any of the preceding embodiments, with the flip-flop in equilibrium, the electrical forces acting across the capacitive elements and the springback force of the axle cancel each other

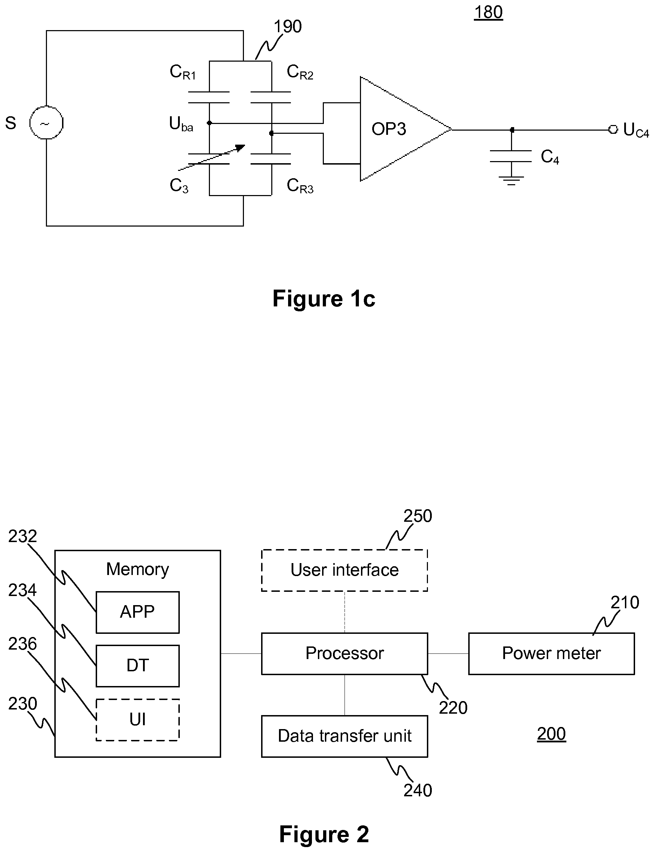

Figs. 1b and 1c depict circuits 160, 180, which are used along with the flip-flop structure 100 for measuring an electric power $P=UI$ flowing in a conductor, wherein the voltage $U$ and the current $I$ are time-dependent quantities with sinusoidal fluctuation for example at 50 Hz frequency. From these are generated two voltage signals $U_U$, $U_I$, whereof $U_U$ is proportional to a voltage measured from the conductor and $U_I$ to a current measured from the conductor.

In a device according to one embodiment of the invention, as set forth in any of the preceding embodiments, the voltage signals arriving at the first and second elements are generated by means of the voltage signal $U_U$ proportional to a voltage measured from the conductor and by means of the voltage signal $U_I$ proportional to a current measured from the conductor.

Fig. 1b shows a voltage circuit 160 for use with the flip-flop structure 100 and intended for the processing of voltage and current signals, wherein across the capacitor C1 is coupled a voltage signal $U_U+U_I$, which is produced with an operation amplifier OP1 functioning as a summing amplifier and which is proportional to the sum of $U_U$ and $U_I$, and across the capacitor C2 is respectively coupled a voltage signal $U_U-U_I$, which is produced with an operation amplifier OP2 functioning as a differential amplifier and which is proportional to the difference between $U_U$ and $U_I$.

In a device according to one embodiment of the invention, as set forth in any of the preceding embodiments, the first and second elements are provided with voltage signals by coupling across the first element a summing voltage signal $U_U+U_I$, which is produced with a first operation amplifier and which is proportional to the sum of a voltage signal proportional to voltage and a voltage signal proportional to current, as well as across the second element a differential voltage signal $U_U-U_I$, which is produced with a second operation amplifier and which is proportional to the difference between a voltage signal proportional to voltage and a voltage signal proportional to current.

The measuring circuit 160 further includes a capacitive attenuator 170 for the suppression of voltage related to electric power to be measured, and a current sensor 172 for the conversion of power-related current into voltage signals of a strength level suitable for the summing amplifier OP1 and the differential amplifier OP2. The current sensor 172 may comprise for example a current transformer or a shunt resistor, or alternatively a Rogowski coil and integrator.

When the capacitors C1 and C2, present on the opposite surfaces 110a, 110b of the flip-flop 110, are energized with the voltages $U_U+U_I$ and $U_U-U_I$ generated as described above, these will result in forces dependent on the voltages $U_U$ and $U_I$, as indicted by the formulae presented below:

$$F_{C1} \propto U_{C1}^2 \propto (U_U + U_I)^2 = U_U^2 + U_I^2 + 2U_U U_I \tag{2}$$

$$F_{C2} \propto U_{C2}^2 \propto (U_U - U_I)^2 = U_U^2 + U_I^2 - 2U_U U_I \tag{3}$$

Since forces $F_{C1}$ and $F_{C2}$ attempt to turn the flip-flop 110 in opposite directions, the result will be an overall force:

$$F_{P,tot} = F_{C1} - F_{C2} \propto U_{C1}^2 - U_{C2}^2 \propto (U_U + U_I)^2 - (U_U - U_I)^2 = 4U_U U_I \propto P \tag{4}$$

According to formula (4), the signals $U_U+U_I$ and $U_U-U_I$ coupled to the capacitors result in a total net force $F_{P,tot}$, which is proportional to the product of $U_U$ and $U_I$, i.e. to the product of $U$ and $I$, which in turn matches the power $P$ to be measured. Therefore, the square of a voltage intended for offsetting the effect of the net force $F_{P,tot}$ is proportional to the power $P$ to be measured from the conductor.

Fig. 1c shows a measuring circuit 180 for use with the flip-flop structure 100 and intended for measuring a capacitance $C_3$, which circuit comprises a bridge circuit 190 feasible for detecting a tilt of the flip-flop 110 caused by the net force $F_{P,tot}$ generated by the signals $U_U+U_I$ and $U_U-U_I$. A tilt-detecting capacitor C3 constitutes one branch of the bridge circuit 190 and its capacitance $C_3$ is measured for example at a frequency considerably higher than that of the voltage $U$ and the current $I$. In the case of fixed capacitance values $C_{R1}$, $C_{R2}$, $C_{R3}$, a voltage $U_{ba}$ of point ba is proportional to the capacitance value $C_3$.

In a device according to one embodiment of the invention, as set forth in any of the preceding embodiments, a change in the flip-flop's position is observed by using a bridge circuit for measuring a measuring element's capacitance, the magnitude of which depends on the distance between the measuring element's electrodes.

An operation amplifier OP3 is used to produce a direct or alternating voltage $U_{C4}$, which is dependent on the

measured capacitance $C_3$ and functions as a feedback signal, and which is fed into a capacitor C4 for holding the flip-flop 110 stationary and for offsetting the total net force $F_{P,tot}$. The feedback voltage $U_{C4}$ enables detecting the instantaneous product of the voltage $U$ and the current $I$, i.e. the power $P$ to be measured, which is proportional to the square of the feedback voltage $U_{C4}$.

In a device according to one embodiment of the invention, as set forth in any of the preceding embodiments, the voltage signal, which is produced with a third operation amplifier and which is to be fed for balancing the flip-flop, is a feedback voltage signal, which is dependent on the measured capacitance of a measuring element and which is proportional to the electric power flowing in a conductor.

Fig. 2 shows a measuring device 200, which is adapted to measure electric power flowing in a conductor by means of a sensor 210 integrated in connection with the conductor, and including a flip-flop which is adapted to rotate relative to its axle. On both sides of the axle, the flip-flop has its top and bottom surfaces provided with electrodes, and each of the flip-flop's four electrodes makes up a part of one capacitor functioning as a capacitive element.

The sensor 210, which is connected to a conductor, includes a measuring unit which comprises voltage and measuring circuits adapted to provide the capacitive elements on the flip-flop's opposite surface with voltage signals, which have an effect on the flip-flop's position and are dependent on the electric power to be measured, to observe by means of the capacitive measuring element a change in the flip-flop's position caused by a change or changes in the voltage signals, and to balance the flip-flop by changing, on the basis of the change in the flip-flop's position, the voltage signal which is to be delivered to a capacitive balancing element and which has its square proportional to the electric power to be measured from a conductor.

The measuring device 200 further includes at least one processor 220, which enables executing for example instructions defined by application programs and processing data, and at least one memory 230 for the storage of data, for example application programs and collected information.

The memory 230 comprises at least a program 232 used for controlling operation of the sensor 210 and for collecting, storing and processing measurement data communicated by the sensor. The sensor's 210 measuring unit conducts the signal processing and the A/D conversion of measurement data into a mode suitable for the processor 220 included in the measuring device and for the program 232, as well as the D/A conversion and the processing of instructions given by the processor 220 into a mode suitable for the sensor 210.

In a device according to one embodiment of the invention, as set forth in any of the preceding embodiments, is included a processor unit, which is adapted to determine an electric power, which is to be measured according to a computer program stored in the device's memory unit, on the basis of a feedback voltage signal delivered to a balancing element, the square of said feedback voltage signal being proportional to the electric power to be measured.

The measuring device 200 further includes a data transfer unit 240 functioning as a data transfer interface, which is why the memory 230 further contains a program 234 intended for controlling data transfer. Thus, the measuring device 200 could be a power meter, which is readable wirelessly and/or over a cable and/or capable of transmitting measurement data independently, and which further includes a separate power supply or power supply unit adapted to take the operating power that it needs for example from an object of measurement. It is also possible to convey the measurement data along an electrical network for example to an actual electricity meter present in a building.

The measuring device may also include at least one user interface 250, which comprises for example a display, at least one function key, a keyboard and/or a touch screen, instead of or in addition to the data transfer unit 240, whereby the memory 230 then also houses necessary programs 236 for controlling the user interface. The measuring devices 200, provided with the display 240, can be applied for example in power meters, as well as in home appliances, extension cords, entertainment electronics, and information networks to indicate the power consumption thereof.

In a device according to one embodiment of the invention, as set forth in any of the preceding embodiments, is further included at least one of the following: a data transfer unit and/or a user interface unit.

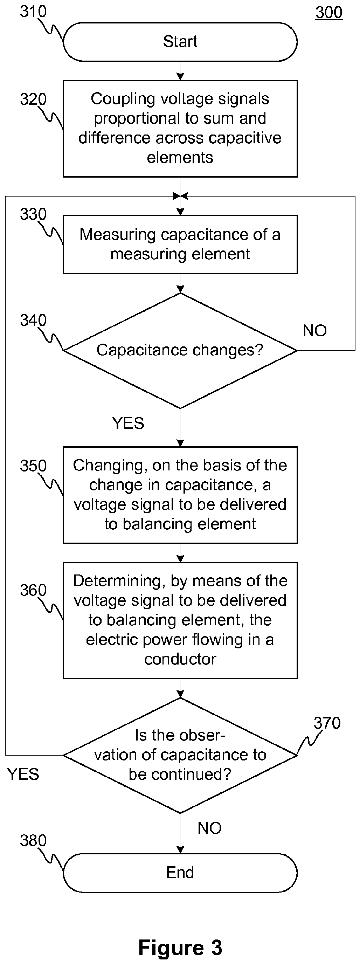

Fig. 3 shows a method 300 intended for measuring electric power, wherein the electric power propagating in a conductor is measured for example by means of a MEMS sensor, which is provided with a flip-flop structure as presented in figs. 1a-1c.

In a method according to one embodiment of the invention, as set forth in any of the preceding embodiments, the flip-flop and the capacitive elements are included in a capacitive micromechanical sensor, on a first side of whose axle, on opposite surfaces, are present first and second elements, and on a second side of the axle, on opposite surfaces, are present a measuring element and a balancing element.

A start phase 310 comprises placing the sensor on an object of measurement and preparing it for a measuring project for example by ensuring both the working condition of the sensor itself and the working condition of components possibly coupled with the sensor, for example a data processing unit, including at least one processor and a memory in which is stored at least one program intended for the processing of measurement data, a user interface, a data transfer unit and/or a display, by running the startup and possible updating programs thereof.

A phase 320, as the sensor is coupled in attachment with a conductor to be measured, comprises generating, by means of a voltage circuit suitable for the processing of voltage and current signals, a voltage signal $U_U$ proportional to a voltage to be measured from the conductor and a current signal $U_I$ proportional to a current to be measured from the conductor, both these signals being dependent on the electric power to be measured.

In a method according to one embodiment of the invention, as set forth in any of the preceding embodiments, the voltage signals arriving at the first and second capacitive elements are generated by means of the voltage signal $U_U$ proportional to a voltage measured from the conductor and by means of the voltage signal $U_I$ proportional to a current measured from the conductor.

By means of the voltage signals $U_U$ and $U_I$, the voltage circuit generates a summing signal $U_U + U_I$ which is coupled across the sensor's one capacitor C1, and a differential signal $U_U - U_I$ which is coupled across a second capacitor C2 present on the opposite side of the flip-flop.

In a method according to one embodiment of the invention, as set forth in any of the preceding embodiments, the first and second elements are provided with voltage signals by coupling across the first element a summing voltage signal $U_U + U_I$, which is proportional to the sum of a voltage signal proportional to voltage and a voltage signal proportional to current, as well as across the second element a differential voltage signal $U_U - U_I$, which is proportional to the difference between a voltage signal proportional to voltage and a voltage signal proportional to current.

While the voltage circuit, which is intended for processing voltage and current signals, is in the process of generating summing and differential signals which have an effect on a tilt of the flip-flop around its axle, a phase 330 marks the start of monitoring with a measuring circuit the capacitance of the sensor's third capacitor C3, i.e. the distance between its capacitor plates. It is just the difference between opposite flip-flop affecting forces generated by the summing and differential signal which has an effect on the distance between the capacitor plates.

In a method according to one embodiment of the invention, as set forth in any of the preceding embodiments, a change in the flip-flop's position is observed by measuring the capacitance of a measuring element, whose magnitude depends on the distance between the measuring element's electrodes.

If the capacitance of the capacitor C3 does not change in phase 340, i.e. the flip-flop is at equilibrium with the forces applied thereto cancelling each other, the measurement will be continued by returning to phase 330.

In a method according to one embodiment of the invention, as set forth in any of the preceding embodiments, when the flip-flop is at equilibrium, the electrical forces working through capacitive elements and the springback force of the axle cancel each other.

On the other hand, if a change occurs regarding the magnitude of the capacitor's C3 capacitance in response to a change in the relationship between forces having an effect on the capacitors C1 and C2, the flip-flop will be balanced in a phase 350 by changing, on the basis of a change in the flip-flop's position, a feedback signal to be delivered to a fourth capacitor C4.

In a method according to one embodiment of the invention, as set forth in any of the preceding embodiments, the voltage signal, which is to be delivered in order to balance the flip-flop, is a feedback voltage signal dependent on the measuring element's measured capacitance and proportional to the electric power flowing in a conductor.

In a phase 360, the feedback signal is used for determining an electric power flowing in a conductor. A message regarding the strength of the feedback signal is communicated to a processor unit connected to the sensor, which uses a computer program stored in the measuring device's memory to determine the magnitude of electric power. The determined power value can be stored for possible further exploitation and/or is presented to the user in real time by means of a display linked to the measuring device. Alternatively, the power value can be indicated by means of audio signals or signal lights.

A method according to one embodiment of the invention, as set forth in any of the preceding embodiments, further comprises determining an electric power to be measured on the basis of a feedback voltage signal delivered to a balancing element, the square of said feedback voltage signal being proportional to the electric power to be measured.

In the event that the capacitance measurement should be continued in a phase 370, a return shall be made to the phase 330. Otherwise the method 300 terminates in a phase 380.

Described above are just a few exemplary embodiments of the invention. The principle according to the invention is naturally modifiable within the scope of protection defined by the claims, regarding for example implementation details as well as fields of use.

**Claims**

1. A method (300) for measuring the electric power propagating in a conductor by using a flip-flop (110), which is adapted to move relative to an axle (140) and which has electrodes (150a, 152a, 154a, 156a) on opposite surfaces (110a, 110b) of the flip-flop, each of said electrodes of the flip-flop being adapted to make up part of a capacitive element (C1, C2, C3, C4),

   **characterized in that** said method comprising

   providing (320) a first element (C1) and a second element (C2) being on the opposite surfaces of the flip-flop or on both sides of its axle with voltage signals ($U_U+U_I$, $U_U-U_I$) having an effect on the flip-flop's position and being dependent on the electric power to be measured, wherein the voltage signals arriving at the first and second elements are generated by means of a voltage signal ($U_U$) proportional to the voltage to be measured from the conductor and by means of a voltage signal ($U_I$) proportional to the current to be measured from the conductor,

observing (330, 340), by means of a measuring element (C3), a change in the flip-flop's position caused by a change in the voltage signals, and

balancing (350) the flip-flop by changing, on the basis of the change in the flip-flop's position, a voltage signal ($U_{C4}$), which is to be delivered to a balancing element (C4) and which is proportional to the electric power to be measured.

2. The method of claim 1, wherein the first and second elements are provided with voltage signals by coupling (320) across the first element a summing voltage signal ($U_U+U_I$) proportional to the sum of the voltage signal proportional to voltage and the voltage signal proportional to current, as well as across the second measuring element a differential voltage signal ($U_U-U_I$) proportional to the difference between the voltage signal proportional to voltage and the voltage signal proportional to current.

3. The method of any of the preceding claims, wherein a change in the flip-flop's position is observed by measuring (330) the measuring element's capacitance, the magnitude of which depends on a distance (d) between the measuring element's electrodes (154a, 154b).

4. The method of any of the preceding claims, wherein the voltage signal to be delivered for balancing the flip-flop is a feedback signal ($U_{C4}$), which is dependent on the measuring element's measured capacitance and which is proportional to the electric power flowing in the conductor.

5. The method of any of the preceding claims, wherein, when the flip-flop is at equilibrium, the electrical forces acting through the capacitive elements and a springback force of the axle cancel each other.

6. The method of any of the preceding claims, which further comprises determining (360) the electric power to be measured on the basis of the feedback signal delivered to the balancing element, the square of said feedback signal being proportional to the electric power to be measured.

7. The method of any of the preceding claims, wherein the flip-flop and the capacitive elements are included in a micromechanical sensor (210), having on a first side of its axle, on its opposite surfaces, first and second elements, and having on a second side of its axle, on its opposite surfaces, a measuring element and a balancing element.

8. A device (100, 160, 180, 210) for measuring the electric power propagating in a conductor, which is adapted to carry out the method of any of claims 1-7.

**Patentansprüche**

1. Verfahren (300) zum Messen der in einem Leiter übertragenen elektrischen Leistung unter Verwendung eines bistabilen Multivibrators (110), der sich relativ zu einer Achse (140) bewegen kann und Elektroden (150a, 152a, 154a, 156a) auf gegenüberliegenden Oberflächen (110a, 110b) des bistabilen Multivibrators aufweist, wobei jede der Elektroden des bistabilen Multivibrators so angepasst ist, dass sie einen Teil eines kapazitiven Elements (C1, C2, C3, C4) bilden;
   **dadurch gekennzeichnet, dass** das Verfahren Folgendes umfasst
   Bereitstellen (320) eines ersten Elements (C1) und eines zweiten Elements (C2) auf den gegenüberliegenden Oberflächen des bistabilen Multivibrators oder auf beiden Seiten seiner Achse mit Spannungssignalen ($U_U+U_I$, $U_U-U_I$), die eine Auswirkung auf die Position des bistabilen Multivibrators haben und abhängig von der zu messenden elektrischen Leistung sind, wobei die am ersten und zweiten Element ankommenden Spannungssignale mittels eines zu der vom Leiter zu messenden Spannung proportionalen Spannungssignals ($U_U$) und mittels eines zu dem vom Leiter zu messenden Strom proportionalen Spannungssignals ($U_I$) erzeugt werden,
   Beobachten (330, 340) mittels eines Messelements (C3) eine Änderung der Position des bistabilen Multivibrators, die durch eine Änderung der Spannungssignale verursacht wird, und
   Ausgleichen (350) des bistabilen Multivibrators durch Ändern eines Spannungssignals ($U_{C4}$), das an ein Ausgleichselement (C4) geliefert werden soll, und das proportional zur zu messenden elektrischen Leistung ist.

2. Verfahren nach Anspruch 1, wobei dem ersten und dem zweiten Element Spannungssignale bereitgestellt werden, indem über das erste Element ein Summierungsspannungssignal ($U_U+U_I$) gekoppelt wird (320), das proportional zur Summe des spannungsproportionalen Spannungssignals und des stromproportionalen Spannungsstroms ist, sowie über das zweite Messelement ein Differenzspannungssignal ($U_U-U_I$), das proportional zur Differenz zwischen dem der spannungsproportionalen Spannungssignal und dem stromproportionalen Spannungssignal ist.

**3.** Verfahren nach einem der vorhergehenden Ansprüche, wobei eine Änderung der Position des bistabilen Multivibrators durch Messen (330) der Kapazität des Messelements beobachtet wird, deren Größe von einem Abstand (d) zwischen den Elektroden des Messelements (154a, 154b) abhängt.

**4.** Verfahren nach einem der vorhergehenden Ansprüche, wobei das zum Ausgleichen des bistabilen Multivibrators zu liefernde Spannungssignal ein Rückkopplungssignal ($U_{C4}$) ist, das von der gemessenen Kapazität des Messelements abhängt, und das proportional zu der im Leiter fließenden elektrischen Leistung ist.

**5.** Verfahren nach einem der vorhergehenden Ansprüche, wobei, wenn sich der bistabile Multivibrator im Gleichgewicht befindet, sich die durch die kapazitiven Elemente wirkenden elektrischen Kräfte und eine Rückfederungskraft der Achse gegenseitig aufheben.

**6.** Verfahren nach einem der vorhergehenden Ansprüche, das ferner das Bestimmen (360) der zu messenden elektrischen Leistung auf der Basis des an das Ausgleichselement gelieferten Rückkopplungssignals umfasst, wobei das Quadrat des Rückkopplungssignals proportional zur zu messenden elektrischen Leistung ist.

**7.** Verfahren nach einem der vorhergehenden Ansprüche, wobei der bistabile Multivibrator und die kapazitiven Elemente in einem mikromechanischen Sensor (210) enthalten sind, der auf einer ersten Seite seiner Achse, auf den gegenüberliegenden Flächen erste und zweite Elemente aufweist und auf einer zweiten Seite seiner Achse auf den gegenüberliegenden Flächen ein Messelement und ein Ausgleichselement aufweist.

**8.** Vorrichtung (100, 160, 180, 210) zum Messen der in einem Leiter übertragenen elektrischen Leistung, die zur Durchführung des Verfahrens nach einem der Ansprüche 1 bis 7 ausgelegt ist.

## Revendications

**1.** Procédé (300) de mesure de la propagation de l'énergie électrique dans un conducteur en utilisant une bascule (110), qui est conçue pour se déplacer par rapport à un essieu (140) et qui a des électrodes (150a, 152a, 154a, 156a) sur des surfaces opposées (110a, 110b) de la bascule, chacune desdites électrodes de la bascule étant conçue pour faire partie d'un élément capacitif (C1, C2, C3, C4),
**caractérisé en ce que** ledit procédé comprend
la fourniture (320) d'un premier élément (C1) et d'un second élément (C2) se trouvant sur les surfaces opposées de la bascule ou des deux côtés de son essieu avec des signaux de tension ($U_U + U_I$, $U_U-U_I$) ayant un effet sur la position de la bascule et dépendant de l'énergie électrique à mesurer, dans lequel les signaux de tension arrivant au niveau des premier et second éléments sont générés au moyen d'un signal de tension ($U_u$) proportionnel à la tension à mesurer du conducteur et au moyen d'un signal de tension ($U_I$) proportionnel au courant à mesurer du conducteur,
l'observation (330, 340), au moyen d'un élément de mesure (C3), d'un changement de position de la bascule provoqué par un changement des signaux de tension, et
l'équilibre (350) de la bascule en changeant, sur la base du changement de position de la bascule, un signal de tension ($U_{C4}$), qui doit être délivré à un élément d'équilibrage (C4) et qui est proportionnel à l'énergie électrique à mesurer.

**2.** Procédé selon la revendication 1, dans lequel les premier et second éléments sont pourvus de signaux de tension en couplant (320) aux bornes du premier élément un signal de tension de sommation ($U_U + U_I$) proportionnel à la somme du signal de tension proportionnel à la tension et du signal de tension proportionnel au courant, ainsi qu'aux bornes du second élément de mesure un signal de tension différentielle ($U_U - U_I$) proportionnel à la différence entre le signal de tension proportionnel à la tension et le signal de tension proportionnel au courant.

**3.** Procédé selon l'une quelconque des revendications précédentes, dans lequel un changement de position de la bascule est observé en mesurant (330) la capacité de l'élément de mesure, dont l'intensité dépend d'une distance (d) entre les électrodes de l'élément de mesure (154a, 154b).

**4.** Procédé selon l'une quelconque des revendications précédentes, dans lequel le signal de tension à délivrer pour équilibrer la bascule est un signal de rétroaction ($U_{C4}$), qui dépend de la capacité mesurée de l'élément de mesure et qui est proportionnel à l'énergie électrique circulant dans le conducteur.

**5.** Procédé selon l'une quelconque des revendications précédentes, dans lequel, lorsque la bascule est à l'équilibre, les forces électriques agissant à travers les éléments capacitifs et une force de retour élastique de l'essieu s'annulent.

**6.** Procédé selon l'une quelconque des revendications précédentes, qui comprend en outre la détermination (360) de l'énergie électrique à mesurer sur la base du signal de rétroaction délivré à l'élément d'équilibrage, le carré dudit signal de rétroaction étant proportionnel à l'énergie électrique à mesurer.

**7.** Procédé selon l'une quelconque des revendications précédentes, dans lequel la bascule et les éléments capacitifs sont inclus dans un capteur micromécanique (210), ayant sur un premier côté de son essieu, sur ses surfaces opposées, des premier et second éléments, et ayant sur un second côté de son essieu, sur ses surfaces opposées, un élément de mesure et un élément d'équilibrage.

**8.** Dispositif (100, 160, 180, 210) de mesure de la propagation de l'énergie électrique dans un conducteur, qui est conçu pour mettre en œuvre le procédé selon l'une quelconque des revendications 1 à 7.

**Figure 1a**

**Figure 1b**

180

**Figure 1c**

200

**Figure 2**

**Figure 3**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2006040403 A